# EUROPEAN PATENT SPECIFICATION

(11) **EP 3 886 134 B1**
(45) Date of publication and mention of the grant of the patent: **29.10.2025**
(21) Application number: 21164444.8
(22) Date of filing: 24.03.2021
(51) Int. Cl.: H01H 57/00, H01H 50/54

(54) **ACTUATION DEVICE, IN PARTICULAR FOR A RELAY**
BETÄTIGUNGSVORRICHTUNG, INSBESONDERE FÜR EIN RELAIS
DISPOSITIF D'ACTIONNEMENT, EN PARTICULIER POUR UN RELAIS

(30) Priority: 25.03.2020 DE 102020203830
(43) Date of publication of application: 29.09.2021
(73) Proprietor: TE Connectivity Germany GmbH, 64625 Bensheim (DE)
(72) Inventor: KROEKER, Matthias, 64625 Bensheim (DE)
(74) Representative: Grünecker Patent- und Rechtsanwälte PartG mbB

(56) References cited:
- EP-A1- 1 587 122
- WO-A1-2014/202687
- DE-A1- 102016 114 531
- GB-A- 2 565 078

## Description

The invention relates to an actuation device, configured for a relay, comprising a base element and a drive rod that is movable relative to the base element, where the actuation device comprises an actuation element for moving the drive rod from a first position to a second position, wherein the actuation element comprises a film or synonymously, a foil or a membrane made of an electroactive polymer.

Such actuation devices are known from prior art and are used, for example, in relays for closing and opening two fixed contacts by way of a switching bridge.

The disadvantage of present actuation devices is that they are heavy and require much installation space.

From WO 2014/202687 A1, an electroactive polymer transducer is known, the transducer comprising a first stack configuration and a second stack configuration, each stack configuration having a multitude of electroactive polymer layers, which are layered on top of each other. Electrodes are disposed between adjacent layers of electroactive polymer, whereby the electrodes of each stack configuration are alternately interconnected to form an electrode arrangement with two interlaced electrode configurations. Each stack configuration has a fixed end and a movable end. The first and second movable ends are coupled together to form a coupling zone for coupling to an external load.

The object of the invention is to provide a solution that is lighter and smaller.

According to the invention, this is satisfied when the drive rod is held in a linearly movable manner on the base element.

As the drive rod is held in linearly movable manner, a controlled motion is enabled

The invention can be further improved by the following developments and embodiments which are advantageous each by itself and can be combined with one another at random.

The first position and the second position of the drive rod can be defined relative to the base element. The base element can serve as a reference. The base element can be mountable to further elements, for example, to a housing that comprises fixed contacts.

During operation, the drive rod can assume the first position or the second position relative to the base element in dependence of a control signal. For example, the drive rod can be in the first position when the control signal has a low value and in the second position when the control signal has a high value. The control signal can be in particular an electrical signal, for example, a voltage.

The actuation element can be arranged, at least functionally, between the base element and the drive rod. The actuation element can then operatively connect the base element and the drive rod. It can ensure that the drive rod is linearly moved relative to the base element. The actuation element can be arranged geometrically between the base element and the drive rod in order to enable a compact design.

For electrical contact, conductive material can be printed onto the electroactive membrane or film on at least one side, in particular a flat side. The printed conductive material can serve as an electrode for the film or membrane. In an advantageous embodiment, conductive material is printed onto both sides of the film. The conductive material can act as a capacitor with two electrodes or plates.

To increase the force and/or the deflection path, the actuation element can comprise several films of the electroactive polymer stacked on top of one another. The stacked films can be in particular in direct contact. They can be stacked with the flat sides abutting against one another The drive rod is held so as to be linearly movable in order to enable a simple motion. The drive rod is held in a manner movable along a straight path from the first position to the second position. In an advantageous embodiment, the drive rod can also be held in a manner movable from the second position back to the first position in a linear manner. The drive rod is held in a linearly movable manner on the base element. The actuation device can comprise guide elements which hold the drive rod in a movable manner.

A direction of motion along which the drive rod moves from the first position to the second position can be parallel to a plane of extension of the film or actuation element. This enables a compact design with a good actuation amplitude.

The direction of motion of the drive rod can be at an angle to the plane of extension of the film or actuation element. This can lead, for example, to increased stability.

In order to secure the drive rod in the second position and, for example, to prevent it from coming loose due to vibrations, the actuation device can comprise a magnetic holding device which holds the drive rod in the second position. The magnetic holding device can comprise in particular at least one magnet, in particular a permanent magnet.

Alternatively or in addition, the magnetic holding device can comprise an electromagnet. Furthermore, a ferromagnetic element or a further magnet can be present. The magnet can be arranged on the base element and the ferromagnetic element on the drive rod or vice versa

The magnetic forces of the magnetic holding device typically have a short reach. The magnetic holding device can be configured in such a way that the magnetic forces substantially act only when connected movable contacts touch fixed contacts and the magnetic holding device builds up a contact force between the movable and the fixed contacts by compressing an overtravel spring. This has the advantage that the closing force of the compression spring can be better adapted to the tension force of the actuation element with the film or the actuation element.

In an alternative embodiment, a differently configured holding device can be present which holds the drive rod in the second position, for example, by way of a latching mechanism. The latching mechanism, like the magnetic holding device, can assume part of the force, e.g., in the region of the overtravel build-up, which presses the movable contacts against the fixed contacts and thereby supports further force-generating elements such as springs.

In an advantageous embodiment, the actuation device can comprise a biasing device which generates a force upon the drive rod in the direction toward the second position when the drive rod is in the first position. The biasing device can be used to move the drive rod from the first position to the second position, in particular when forces upon other elements, such as the actuation element, are changed. The biasing device can attempt to move the drive rod toward the second position when it is in the first position.

The biasing device can comprise a spring, in particular a helical spring. The spring can generate the force in a simple manner. The spring can be a compression spring which generates a force when it is compressed, in particular a force which presses contacts on a switching bridge of a relay against fixed contacts.

In the first position, a force generated by the actuation element upon the drive rod can press the drive rod against a stop in order to position it securely.

In an alternative or additional configuration, a force generated in the first position by the actuation element upon the drive rod can compensate for a force generated upon the drive rod by the biasing device and a magnetic holding device possibly present. As a result, the drive rod can be held without a stop and, for example, prevent vibrations due to striking the stop.

In an advantageous embodiment, the film or membrane can be configured as a strip. The strip can be attached at two oppositely disposed ends. For the remainder, the strip can be free and not attached or clamped in, in particular on the longitudinal sides. A simple configuration can then be possible.

In a configuration that enables a reliable and uniform motion, the actuation element can comprise two film sections spaced apart from one another perpendicular to a direction of motion of the drive rod.

The spacing between the film sections can be 100 to 500 percent of a spacing between the drive rod in the first position and in the second position. Due to a leverage effect, the tolerances arising in the region of the film sections can then have little effect on a motion of the drive rod. For the same reasons, the spacing can be 100 to 500 percent of a length of the drive rod in the direction of motion.

The two film sections can be two separate films, for example, to save film material.

In order to bring about, for example, a linear motion in a simple manner, the two film sections can be arranged symmetrically relative to the drive rod. For example, they can be merged into one another by way of a mirror symmetry or a twofold rotational symmetry. The mirror plane or axis of rotation, respectively, can run parallel to the direction of motion of the drive rod. The drive rod can likewise be configured to be symmetrical in order to enable simple assembly.

In an advantageous embodiment, the two film sections can be partial sections of a single film and a force-absorbing element of the drive rod can abut against a connection section between the two partial sections. For example, the drive rod can be suspended from the connection section. In a special configuration, the film can extend upwardly, transversely, and again downwardly, i.e., approximately in a U-shape. The film can form a loop which encloses a force-absorbing element of the drive rod and/or from which the force-absorbing element is suspended.

In a compact configuration, the film can be arranged on the drive rod in part between the force-absorbing element and part of the magnetic holding device. In particular, the film can be clamped in or otherwise mechanically held, e.g., by elements for suspension adhesively bonded in order to keep the construction simple.

In an advantageous embodiment, a force-absorbing element of the drive rod and/or part of the magnetic holding device on the drive rod can be used to establish electrical contact with the film. Such a dual function can save components.

The force-absorbing element can be configured as a plate in order to operate in a particularly space-saving manner. The plate can have in particular rounded edges to avoid damage to the film.

The force-absorbing element can be configured as part of the biasing device, for example, as a support element for a spring. Components can be saved with such a dual function.

In order to save space, the drive rod and/or the biasing device can be located at least in part between the two spaced film sections. For example, the drive rod and/or the biasing device can be arranged in a spatial region which is enclosed by the film at least on two oppositely disposed sides.

The actuation device can comprise a printed circuit board with electrical components attached thereto for controlling the motion of the drive rod. In an alternative embodiment, electrical components for control purposes can be present outside the actuation device.

The actuation device can comprise an electrical component for generating an actuation voltage as a function of a control voltage. For example, the electrical component can convert the control voltage into the actuation voltage. This can be done, for example, using a step-up converter.

In an advantageous embodiment, the film can be held mechanically by being clamped between the printed circuit board and a clamping element. The printed circuit board can then fulfill a dual function and the number of components can be reduced.

At least one electrode of the film can be electrically contacted by mechanical clamping, for example, by being clamped to the printed circuit board and/or the clamping element.

In further configurations, the drive rod can assume still further positions, for example, a third position or a fourth position. In a further configuration, the drive rod can also assume a continuous or quasi-continuous spectrum of positions.

Electroactive polymers (EAP) can be understood to be polymers that change their shape when an electrical voltage is applied. For example, they can be ionic EAP or electronic EAP. In particular, the electroactive polymer can be a dielectric polymer. The electroactive polymer can be silicone or acrylic or comprise silicone or acrylic.

The films according to the invention can have in particular a thickness between 5 and 500 µm.

A relay according to the invention comprises an actuation device according to the invention.

In the following, the invention shall be described by way of example in detail with reference to the drawings using advantageous configurations. The advantageous further developments and configurations illustrated there are each independent of each other and can be combined with one another in dependence of the requirement of the application,
where
- Fig. 1: shows a schematic perspective view of an actuation device;
- Fig. 2: shows a further schematic perspective view of the actuation device from Figure 1;
- Fig. 3: shows a schematic perspective view of a single film;
- Fig. 4: shows a schematic side view of several films stacked on top of one another;
- Fig. 5: shows a schematic partially sectioned side view of a relay with an actuation device with the drive rod in a first position;
- Fig. 6: shows a schematic partially sectioned side view of a relay with an actuation device with the drive rod in a second position;
- Fig. 7: shows a schematic representation of the force as a function of the path of the drive rod;
- Fig. 8: shows a schematic perspective view of a film with fastening elements;
- Fig. 9: shows a schematic top view of the film from Figure 8;

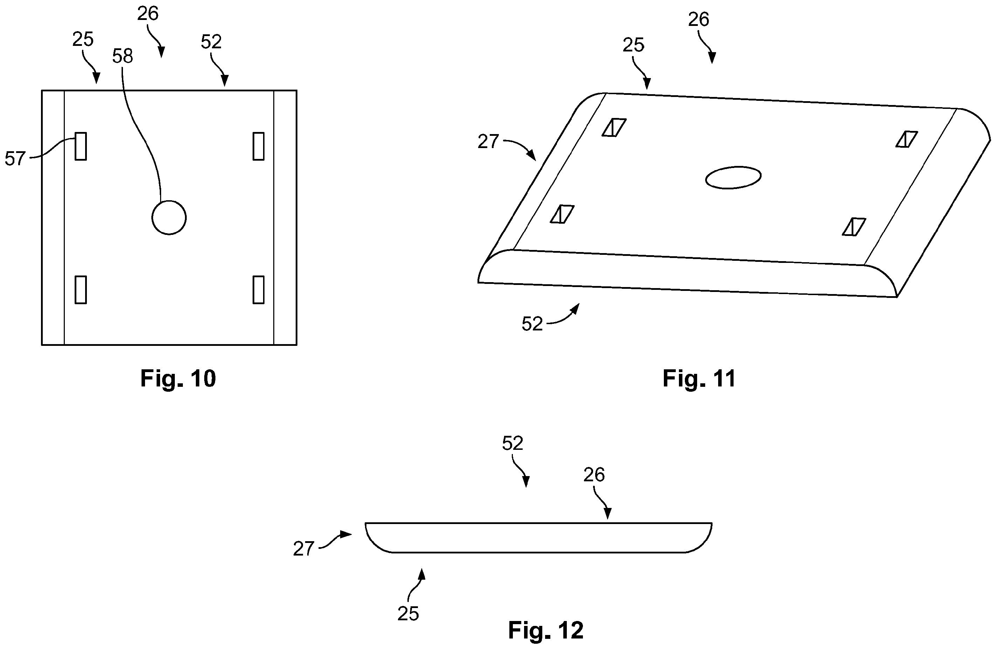

- Fig. 10: shows a schematic top view of a force-absorbing element;
- Fig. 11: shows a schematic perspective view of the force-absorbing element from Figure 10;
- Fig. 12: shows a schematic side view of the force-absorbing element from Figure 10.

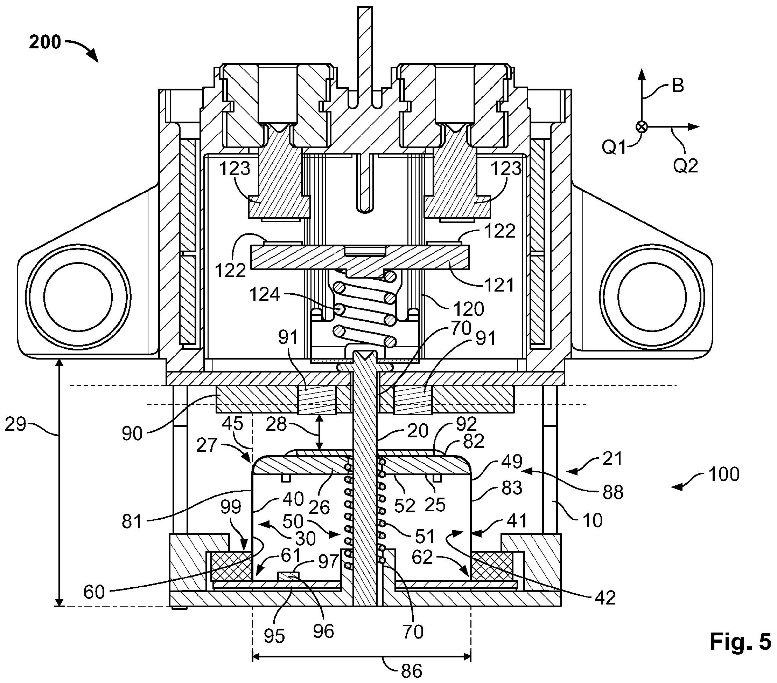

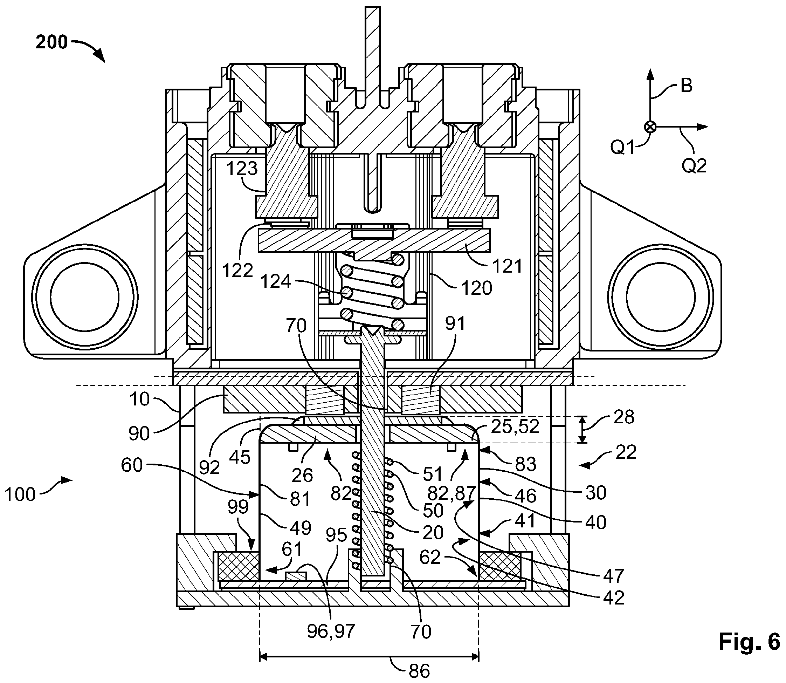

The figures show an advantageous configuration of an actuation device 100 for a relay 200. As can be seen, for example, in Figures 5 and 6, relay 200 can comprise further elements in addition to actuation device 100, in particular a switching bridge 121 connected by way of a switching bridge support 120 to a drive rod 20 of actuation device 100. Switching bridge 121 comprises two movable contacts 122 which, depending on the position of drive rod 20, connect or do not connect two fixed contacts 123 by way of switching bridge 121 and thereby open or close a connected circuit. An overtravel spring 124 between switching bridge support 120 and switching bridge 121 biases switching bridge 121 toward fixed contacts 123 and generates a pressing force which in the closed state presses movable contacts 122 against fixed contacts 123.

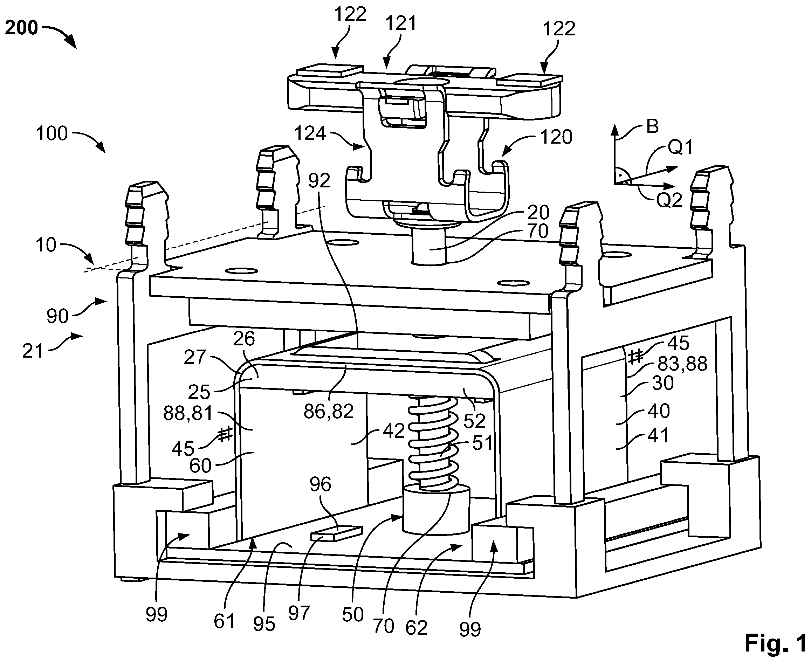

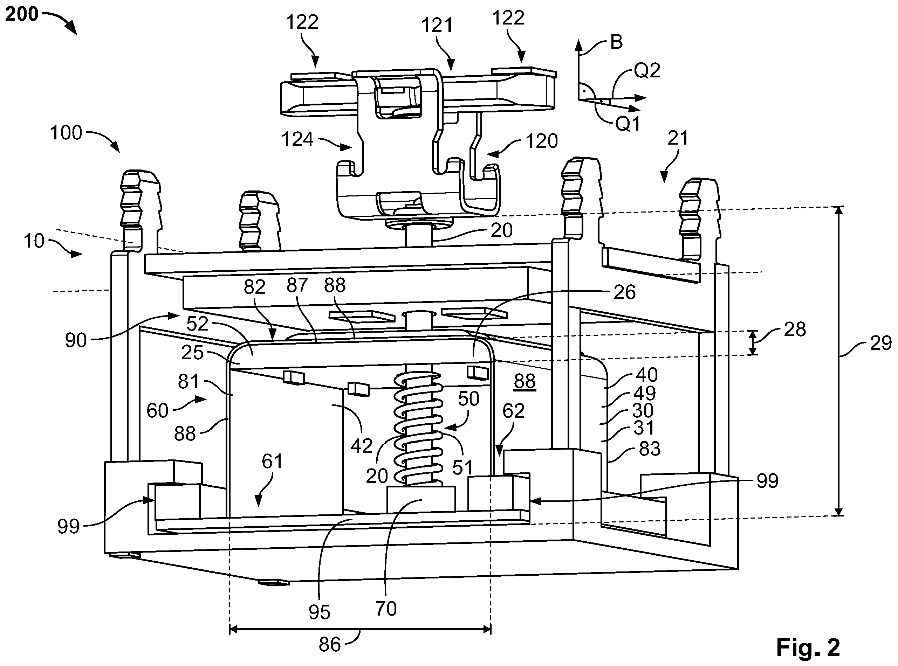

Actuation device 100 comprises a base element 10 that serves as a reference and a frame. Furthermore, actuation device 100 disposes of drive rod 20 which is movable relative to base element 10 along a direction of motion B. The motion of drive rod 20 can be controlled by a control current or control voltage. Drive rod 20 can be transferred from a first position 21, as shown, for example, in Figures 1, 2 and 5, to a second position 22, as shown, for example, in Figure 6. First position 21 and second position 22 are there defined relative to base element 10. For this motion, actuation device 100 comprises an actuation element 30 which, in the embodiment shown, comprises a film 40 made of an electroactive polymer 49. The film 40 can synonymously be called a foil or a membrane. Compared to other configurations in which, for example, a coil is used, the configuration with an electroactive membrane or film 40 made of an electroactive polymer 49 is lighter and more compact. Furthermore, this solution can be more economical.

Actuation element 30 is operatively arranged between base element 10 and drive rod 20, it therefore establishes an operative connection between the two elements. In the present case, it is also arranged geometrically between base element 10 and drive rod 20.

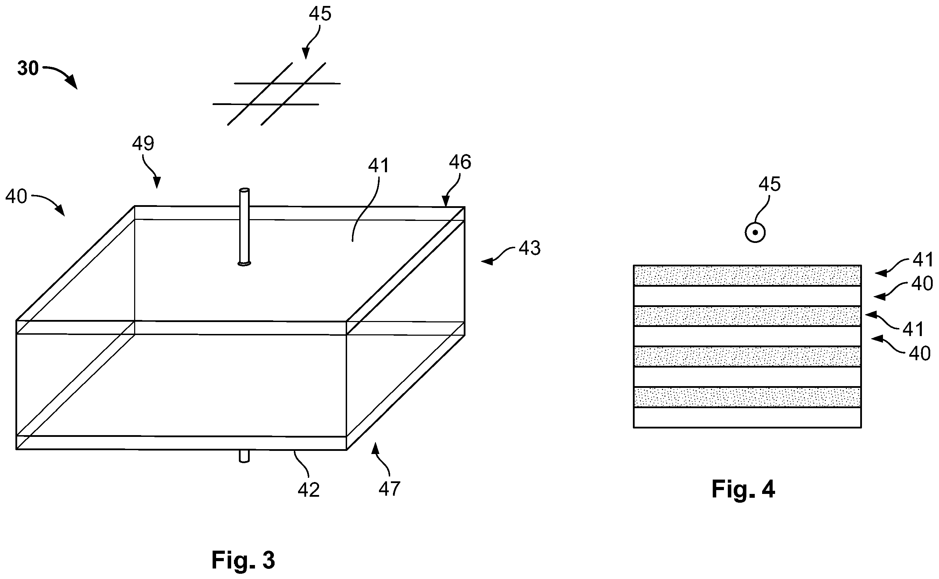

The principle of action of film 40 with electroactive polymer 49 is shown in Figure 3. An elastic layer 43, for example made of silicone, is coated with electrically conductive material on first flat side 46 and second flat side 47. The coatings form a first electrode 41 and a second electrode 42, respectively. The two electrodes 41, 42 act like a capacitor. When a high voltage is applied between two electrodes 41, 42, they are drawn to one another and thereby squeeze elastic layer 43 together. This leads to a reduction in the thickness of elastic layer 43 and, as a result, to a greater expansion in plane of extension 45 of film 40.

As shown in Figure 4, several such films 40 can optionally be stacked on top of one another, for example, in order to obtain a greater force.

Actuation device 100 further comprises a biasing device 50 which comprises in particular a spring 51 and which acts upon a force-absorbing element 25 of drive rod 20. Biasing device 50 attempts to push drive rod 20 to second position 22 when drive rod 20 is in first position 21 in that it exerts a force upon force-absorbing element 25 and therefore upon the remainder of drive rod 20 that is firmly connected to force-absorbing element 25. In second position 22 there can be no force exerted by biasing device 50 or such force can be very small, for example, only 5 percent or less than the force in first position 21.

In order to hold drive rod 20 in second position 22, actuation device 100 comprises a magnetic holding device 90, in the present case magnets 91 fixedly connected to base element 10 and a ferromagnetic element 92 in the form of a plate which is movable relative thereto and fixedly connected to the remainder of drive rod 20. Since the magnetic holding forces acting have a rapidly declining profile, magnetic holding device 90 acts primarily in the vicinity of second position 22. The effect can be present in particular when movable contacts 122 touch fixed contacts 123. The magnetic force can then tension overtravel spring 124, which in turn presses movable contacts 122 against fixed contacts 123. The contact force between movable contacts 122 and fixed contacts 123 is then substantially independent of the force that biasing device 50 generates with spring 51.

In the embodiment shown, film 40 comprises a first film section 81, an adjoining second film section 82, and an adjoining third film section 83, which overall form a U-shape. First film section 81 and third film section 83 are spaced from one another along a second transverse direction Q2 which runs perpendicular to direction of motion B of drive rod 20, but each run parallel to direction of motion B and parallel to one another. The plane of extension 45 in these sections 81 and 83s is therefore parallel to direction of motion B. Plane of extension 45 in first section 81 and in third section 83 also runs along a first transverse direction Q1 which is perpendicular to direction of motion B and perpendicular to second transverse direction Q2.

Second film section 82 forms a connection section 87 against which force-absorbing element 25 abuts, but which is not necessarily responsible for a motion of drive rod 20. Such motion takes place due to a change in length in the region of first section 81 and third section 83 which are each partial sections 88 of film 40.

Film 40 in second film section 82 is clamped between force-absorption element 25, which is configured as a plate 26 with rounded edges 27, and ferromagnetic element 92 of magnetic holding device 90, which is likewise configured as a plate 26. Connection elements on ferromagnetic element 92 protrude through holes 57 in film 40 and force-absorbing element 25.

In first position 21, the resilient force of elastic layer 43 of film 40 acts against the force of spring 51 and the force of magnetic holding device 90 and holds drive rod 20 without a stop in first position 21. When actuation element 30 is actuated by applying a high voltage between electrodes 41, 42, the force of elastic layer 43 is compensated for in part by the attracting force of electrodes 41 and 42 to one another, so that the forces in the direction of second position 22 predominate and drive rod 20 moves towards second position 22. As long as the voltage is applied, drive rod 20 then remains in second position 22. If the voltage is removed, the resilient force of elastic layer 43 prevails again in film 40 and drive rod 20 is retracted to first position 21.

In addition to first position 21 and second position 22, further positions can be present, for example, a third position which is disposed between first position 21 and second position 22 and in which drive rod 20 is held, for example, due to an equilibrium of forces. A continuous spectrum of positions between first position 21 and second position 22 is also possible if, for example, the voltage between two electrodes 41, 42 can be adjusted steplessly.

Drive rod 20 is held linearly movable in base element 10 by way of guide elements 70.

Film 40 shown is configured as a strip 60 in which a first end 61 and a second end 62 disposed opposite to first end 61 are clamped between a printed circuit board 95 and a clamping element 99 and are thereby held mechanically. As a result of the clamping, electrical contact can also be established at the same time, for example, via conductive elements on printed circuit board 95 or clamping element 99.

Force-absorbing element 25 of drive rod 20 and ferromagnetic element 92 can likewise be used to establish an electrical contact with electrodes 41, 42.

A spacing 86 between first film section 81 and third film section 83 can be 100 to 500 percent of a spacing 28 between first position 21 and second position 22 of drive rod 20. Furthermore, spacing 86 can be 100 to 500 percent of a length 29 of drive rod 20. As a result, tolerances in the region of film 40 can lead to minor errors in the motion of drive rod 20. The error tolerance is further improved by the symmetrical configuration of film sections 81, 83.

Drive rod 20 and biasing device 50 are disposed at least in part between two film sections 81, 83 spaced apart, so that actuation device 100 is compact.

Force-absorbing element 25 fulfills a dual function and at the same time serves as a support element 52 for biasing device 50.

Electrical components 96, for example, a step-up converter 97 which converts an incoming voltage to a higher voltage can be present on printed circuit board 95.

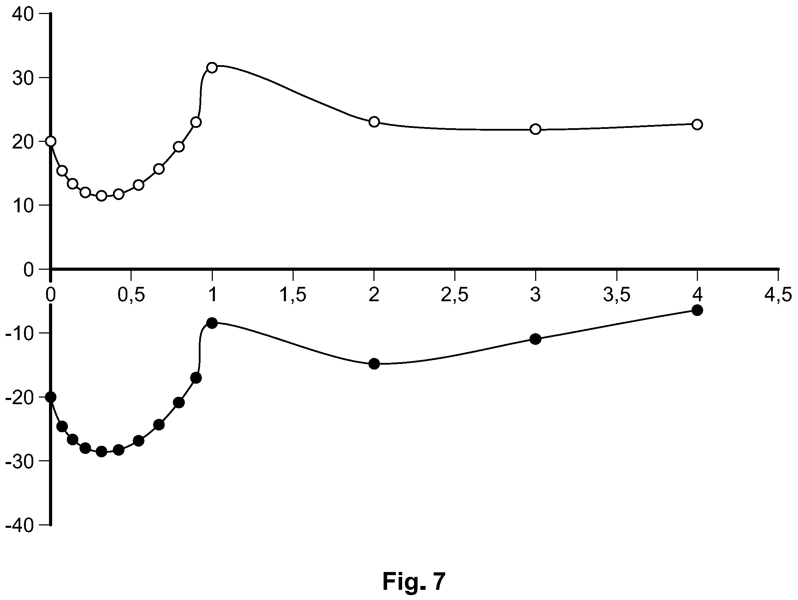

A force profile of actuation device 100 is shown in Figure 7. The upper and lower graphs correspond to the two cases where a voltage or no voltage is applied to film 40. The force profile is the sum of the resilient force of elastic layer 43, the force generated by two electrodes 41, 42, the magnetic force by magnetic holding device 90, the force of spring 51 of biasing device 50, and the force of overtravel spring (124) which is built up when contacts 122, 123 are closed.

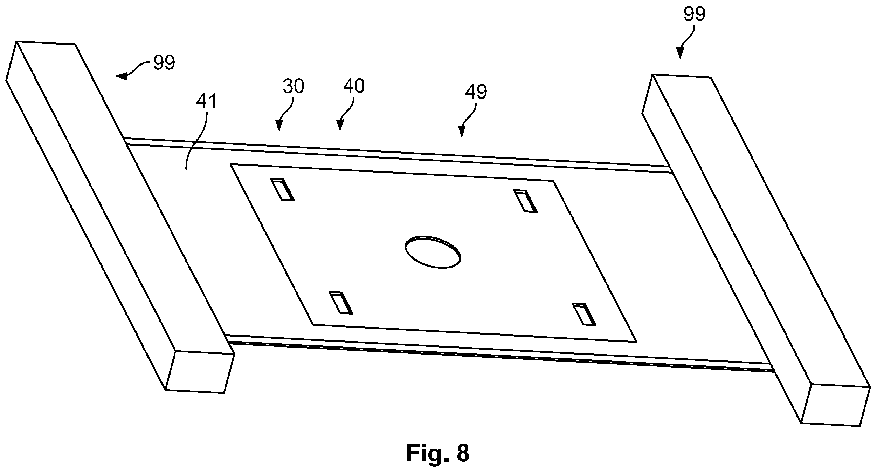

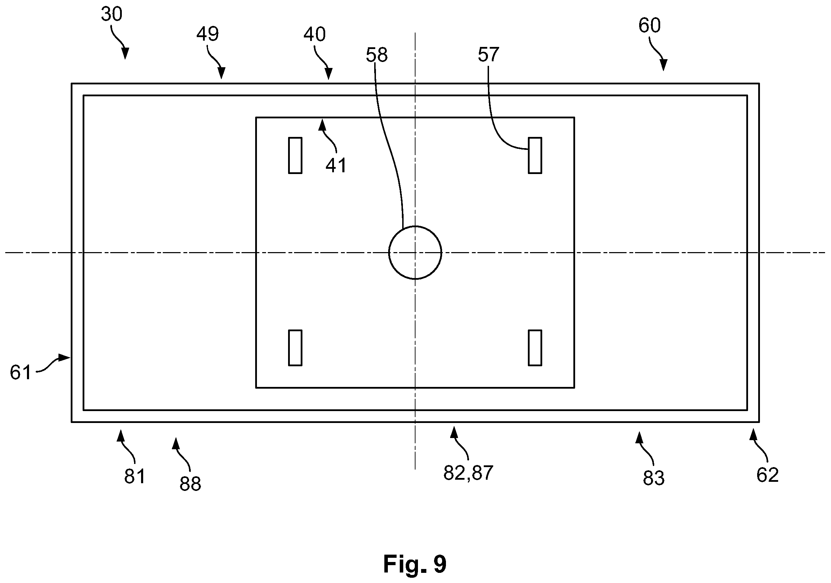

As can be seen in Figures 8 and 9, there does not necessarily have to be a wide-surface coating present with a conductive material in the region of second section 82 of film 40. In this region, for example, parts of elastic layer 43 can be seen due to the lack of such an electrode 41 and 42. In second film section 82, holes 57 for the mechanical connection of ferromagnetic element 92 to force-absorbing element 21 and a hole 58 for passing drive rod 20 through are also present. It can also be seen that elastic layer 43 is also exposed in the region of the edge of strip 60 and no electrodes 41, 42 are formed there. This can prevent, for example, undesired contacting.

### Reference numerals

- 10: base element
- 20: drive rod
- 21: first position
- 22: second position
- 25: force-absorbing element
- 26: plate
- 27: rounded edge
- 28: spacing first position - second position
- 29: length of drive rod
- 30: actuation element
- 40: film
- 41: first electrode
- 42: second electrode
- 43: elastic layer
- 45: plane of extension
- 46: first flat side
- 47: second flat side
- 49: electroactive polymer
- 50: biasing device
- 51: spring
- 52: support element
- 57: hole
- 58: hole
- 60: strip
- 61: first end
- 62: second end
- 70: guide element
- 81: first film section
- 82: second film section
- 83: third film section
- 86: spacing film sections
- 87: connection section
- 88: partial section
- 90: magnetic holding device
- 91: magnet
- 92: ferromagnetic element
- 95: printed circuit board
- 96: electrical component
- 97: step-up converter
- 99: clamping element
- 100: actuation device
- 120: switching bridge support
- 121: switching bridge
- 122: movable contacts
- 123: fixed contacts
- 124: overtravel spring
- 200: relay

- B: direction of motion
- Q1: first transverse direction
- Q2: second transverse direction

## Claims

1. Actuation device (100), configured for a relay (200), comprising a base element (10) and a drive rod (20) that is movable relative to said base element, where said actuation device (100) comprises an actuation element (30) for moving said drive rod (20) from a first position (21) to a second position (22), where said actuation element (30) comprises a film (40) made of an electroactive polymer (49), **characterized in that** the drive rod (20) is held in a linearly movable manner on the base element (10).

2. Actuation device (100) according to claim 1, where said actuation element (30) is arranged between said base element (10) and said drive rod (20).

3. Actuation device (100) according to one of the claims 1 or 2, where conductive material is printed onto said film (40) on at least one side (46, 47).

4. Actuation device (100) according to one of the claims 1 to 3, where said actuation element (30) comprises several films (40) stacked on top of one another.

5. Actuation device (100) according to one of the claims 1 to 4, where the actuation device (100) comprises guide elements (70), which hold the drive rod (20) in the linearly movable manner.

6. Actuation device (100) according to one of the claims 1 to 5, where a direction of motion (B), along which said drive rod (20) moves from said first position (21) to said second position (22), is parallel to a plane of extension (45) of said film (40).

7. Actuation device (100) according to one of the claims 1 to 6, where said actuation device (100) comprises a magnetic holding device (90) which holds said drive rod (20) in said second position (22).

8. Actuation device (100) according to one of the claims 1 to 7, where said actuation device (100) comprises a biasing device (50) which generates a force upon said drive rod (20) in the direction toward said second position (22) when said drive rod (20) is in said first position (21).

9. Actuation device (100) according to one of the claims 1 to 8, where said film (40) is configured as a strip (60) which is attached at two oppositely disposed ends (61, 62).

10. Actuation device (100) according to one of the claims 1 to 9, where said actuation element (30) comprises two film sections (81, 83) spaced from one another perpendicular to a direction of motion (B) of said drive rod (20).

11. Actuation device (100) according to claim 10, where said two film sections (81, 83) are partial sections (88) of a single film (40) and a force-absorbing element (25) of said drive rod (20) abuts against a connection section (82) between said two partial sections (81, 83).

12. Actuation device (100) according to one of the claims 10 or 11, where said drive rod (20) and/or said biasing device (50) is disposed at least in part between said two spaced film sections (81, 83).

13. Actuation device (100) according to one of the claims 1 to 12, where said actuation device (100) comprises a printed circuit board (95) with electrical components (96) attached thereto for controlling the motion of said drive rod (20).

14. Actuation device (100) according to one of the claims 1 to 13, where at least one electrode (41, 42) of said film (40) is electrically contacted by mechanical clamping.

15. Relay (200) comprising an actuation device (100) according to one of the claims 1 to 14.

## Patentansprüche

1. Betätigungsvorrichtung (100) für ein Relais (200), mit einem Basiselement (10) und einer relativ zu diesem bewegbaren Antriebsstange (20), wobei die Betätigungsvorrichtung (100) ein Betätigungselement (30) zum Bewegen der Antriebsstange (20) aus einer ersten Position (21) in eine zweite Position (22) aufweist, wobei das Betätigungselement (30) eine Folie (40) aus einem elektroaktiven Polymer (49) aufweist, **dadurch gekennzeichnet, dass** die Antriebsstange (20) an dem Basiselement (10) linear bewegbar gehalten ist. (22) zu bewegen, wobei das Betätigungselement (30) eine aus einem elektroaktiven Polymer (49) gefertigte Folie (40) aufweist, **dadurch gekennzeichnet, dass** die Antriebsstange (20) an dem Basiselement (10) linear beweglich gehalten ist.

2. Betätigungsvorrichtung (100) nach Anspruch 1, wobei das Betätigungselement (30) zwischen dem Basiselement (10) und der Antriebsstange (20) angeordnet ist.

3. Betätigungsvorrichtung (100) nach einem der Ansprüche 1 oder 2, wobei auf die Folie (40) auf mindestens einer Seite (46, 47) leitfähiges Material gedruckt ist.

4. Betätigungsvorrichtung (100) nach einem der Ansprüche 1 bis 3, wobei das Betätigungselement (30) mehrere übereinandergeschichtete Folien (40) aufweist.

5. Betätigungsvorrichtung (100) nach einem der Ansprüche 1 bis 4, wobei die Betätigungsvorrichtung (100) Führungselemente (70) aufweist, die die Antriebsstange (20) linear bewegbar halten.

6. Betätigungsvorrichtung (100) nach einem der Ansprüche 1 bis 5, wobei eine Bewegungsrichtung (B), in der sich die Antriebsstange (20) aus der ersten Position (21) in die zweite Position (22) bewegt, parallel zu einer Ausdehnungsrichtung (45) der Folie (40) verläuft.

7. Betätigungsvorrichtung (100) nach einem der Ansprüche 1 bis 6, wobei die Betätigungsvorrichtung (100) eine magnetische Haltevorrichtung (90) aufweist, die die Antriebsstange (20) in der zweiten Position (22) hält.

8. Betätigungsvorrichtung (100) nach einem der Ansprüche 1 bis 7, wobei die Betätigungsvorrichtung (100) eine Vorspannvorrichtung (50) aufweist, die eine Kraft auf die Antriebsstange (20) in Richtung auf die zweite Position (22) erzeugt, wenn sich die Antriebsstange (20) in der ersten Position (21) befindet.

9. Betätigungsvorrichtung (100) nach einem der Ansprüche 1 bis 8, wobei die Folie (40) als Streifen (60) ausgebildet ist, der an zwei gegenüberliegenden Enden (61, 62) befestigt ist.

10. Betätigungsvorrichtung (100) nach einem der Ansprüche 1 bis 9, wobei das Betätigungselement (30) zwei senkrecht zu einer Bewegungsrichtung (B) der Antriebsstange (20) voneinander beabstandete Folienabschnitte (81, 83) aufweist.

11. Betätigungsvorrichtung (100) nach Anspruch 10, wobei die beiden Folienabschnitte (81, 83) Teilabschnitte (88) einer einzigen Folie (40) sind und ein Kraft aufnehmendes Element (25) der Antriebsstange (20) an einem Verbindungsabschnitt (82) zwischen den beiden Teilabschnitten (81, 83) anliegt.

12. Betätigungsvorrichtung (100) nach einem der Ansprüche 10 oder 11, wobei die Antriebsstange (20) und/oder die Vorspannvorrichtung (50) zumindest teilweise zwischen den beiden beabstandeten Folienabschnitten (81, 83) angeordnet ist.

13. Betätigungsvorrichtung (100) nach einem der Ansprüche 1 bis 12, wobei die Betätigungsvorrichtung (100) eine gedruckte Leiterplattenanordnung (95) mit darauf angebrachten elektrischen Bauteilen (96) zur Steuerung der Bewegung der Antriebsstange (20) aufweist.

14. Betätigungsvorrichtung (100) nach einem der Ansprüche 1 bis 13, wobei mindestens eine Elektrode (41, 42) der Folie (40) durch mechanische Klemmung elektrisch kontaktiert ist.

15. Relais (200) mit einer Betätigungsvorrichtung (100) nach einem der Ansprüche 1 bis 14.

## Revendications

1. Dispositif d'actionnement (100), configuré pour un relais (200), comprenant un élément de base (10) et une tige d'entraînement (20) qui est mobile par rapport audit élément de base, où ledit dispositif d'actionnement (100) comprend un élément d'actionnement (30) pour déplacer ladite tige d'entraînement (20) d'une première position (21) à une seconde position (22), où ledit élément d'actionnement (30) comprend un film (40) constitué d'un polymère électroactif (49), **caractérisé en ce que** la tige d'entraînement (20) est maintenue d'une manière linéairement mobile sur l'élément de base (10).

2. Dispositif d'actionnement (100) selon la revendication 1, où ledit élément d'actionnement (30) est agencé entre ledit élément de base (10) et ladite tige d'entraînement (20).

3. Dispositif d'actionnement (100) selon l'une des revendications 1 ou 2, où un matériau conducteur est imprimé sur ledit film (40) sur au moins un côté (46, 47).

4. Dispositif d'actionnement (100) selon l'une des revendications 1 à 3, où ledit élément d'actionnement (30) comprend plusieurs films (40) empilés les uns sur les autres.

5. Dispositif d'actionnement (100) selon l'une des revendications 1 à 4, où le dispositif d'actionnement (100) comprend des éléments de guidage (70), qui maintiennent la tige d'entraînement (20) de la manière linéairement mobile.

6. Dispositif d'actionnement (100) selon l'une des revendications 1 à 5, où une direction de mouvement (B), le long de laquelle ladite tige d'entraînement (20) se déplace de ladite première position (21) à ladite seconde position (22), est parallèle à un plan d'extension (45) dudit film (40).

7. Dispositif d'actionnement (100) selon l'une des revendications 1 à 6, où ledit dispositif d'actionnement (100) comprend un dispositif de maintien magnétique (90) qui maintient ladite tige d'entraînement (20) dans ladite seconde position (22).

8. Dispositif d'actionnement (100) selon l'une des revendications 1 à 7, où ledit dispositif d'actionnement (100) comprend un dispositif de sollicitation (50) qui génère une force sur ladite tige d'entraînement (20) dans la direction vers ladite seconde position (22) lorsque ladite tige d'entraînement (20) est dans ladite première position (21).

9. Dispositif d'actionnement (100) selon l'une des revendications 1 à 8, où ledit film (40) est configuré sous forme d'une bande (60) qui est fixée au niveau de deux extrémités disposées de manière opposée (61, 62).

10. Dispositif d'actionnement (100) selon l'une des revendications 1 à 9, où ledit élément d'actionnement (30) comprend deux sections de film (81, 83) espacées l'une de l'autre perpendiculairement à une direction de mouvement (B) de ladite tige d'entraînement (20).

11. Dispositif d'actionnement (100) selon la revendication 10, où lesdites deux sections de film (81, 83) sont des sections partielles (88) d'un film unique (40) et un élément absorbant la force (25) de ladite tige d'entraînement (20) s'appuie contre une section de connexion (82) entre lesdites deux sections partielles (81, 83).

12. Dispositif d'actionnement (100) selon l'une des revendications 10 ou 11, où ladite tige d'entraînement (20) et/ou ledit dispositif de sollicitation (50) est disposé au moins en partie entre lesdites deux sections de film espacées (81, 83).

13. Dispositif d'actionnement (100) selon l'une des revendications 1 à 12, où ledit dispositif d'actionnement (100) comprend une carte de circuit imprimé (95) avec des composants électriques (96) fixés à celle-ci pour commander le mouvement de ladite tige d'entraînement (20).

14. Dispositif d'actionnement (100) selon l'une des revendications 1 à 13, où au moins une électrode (41, 42) dudit film (40) est électriquement mise en contact par serrage mécanique.

15. Relais (200) comprenant un dispositif d'actionnement (100) selon l'une des revendications 1 à 14.
